Europäisches Patentamt

European Patent Office

Office européen des brevets

(11) Publication number: **0 430 040 A2**

# EUROPEAN PATENT APPLICATION

(21) Application number: 90122197.8

(22) Date of filing: 20.11.90

(51) Int. Cl.⁵: **H01L 21/90, H01L 21/321**

(30) Priority: 27.11.89 US 441611

(43) Date of publication of application:
05.06.91 Bulletin 91/23

(84) Designated Contracting States:
DE Bulletin 11/

(71) Applicant: MICRON TECHNOLOGY, INC.
2805 East Columbia Road
Boise, ID 83706(US)

(72) Inventor: Doan,Trung Tri
1574 Shenandoah Drive
Boise,Ada County, Idaho 83712(US)

(74) Representative: Klunker . Schmitt-Nilson .
Hirsch
Winzererstrasse 106
W-8000 München 40(DE)

(54) Method of forming a conductive via plug or an interconnect line of ductile metal within an integrated circuit using mechanical smearing.

(57) A method of forming a conductive via plug or an interconnect line, or both, of ductile metal within an integrated circuit using mechanical smearing. The process begins with a wafer having a dielectric layer (16), the upper surface of which has been planarized. If both conductive via plugs and interconnect lines are both required within the circuit, a first photomask (17) defines the interconnect lines. A first etch creates channels (18) in the interconnect line locations. A second photomask (19) defines the vias. A second etch creates the vias (20) which pass through the dielectric layer to conductive regions (14) below where contact is to be made. A ductile metal layer (21) is then deposited on top of the dielectric layer (16). The ductile metal layer (21) is then mechanically smeared or deformed in order to force metal from that layer more deeply into the channels (18) and vias (20). The wafer is then slurry polished until all excess metal is removed and the via and channel topography is coplanar with the dielectric layer surface. At this point conductive via plugs (22) and interconnect lines (23) are fully formed.

FIG. 11

# METHOD OF FORMING A CONDUCTIVE VIA PLUG OR AN INTERCONNECT LINE OF DUCTILE METAL WITHIN AN INTEGRATED CIRCUIT USING MECHANICAL SMEARING

## Field of the Invention

This invention relates to semiconductor manufacturing technology and, more specifically, to methods for creating metal interconnections between conductive layers and metal interconnect lines in sub-micron manufacturing processes.

## Background of the Invention

As semiconductor device dimensions become finer and finer, it becomes increasingly difficult to obtain adequate step coverage within interconnect vias using metal that has been deposited by traditional deposition techniques. In addition, traditional methods of forming metal interconnect lines are affected by particle contamination and defective metal layer etches. Generally, particle contamination is responsible for open circuits in the metal interconnect system, while a defective etch of a metal layer may result in both shorted or open circuits. Another problem associated with the creation of metal interconnect lines is that metal layers are relatively difficult to etch as compared, for example, to silicon dioxide. As device dimensions become smaller, electromigration becomes a more significant problem. Since electromigration in semiconductor devices is generally associated the use of pure aluminum for interconnect lines, the problem is most easily eliminated by alloying other metals, such as copper, with aluminum. However, alloys of aluminum that do not exhibit at least minimal grain-boundary diffusion in the presence of an electric current are generally relatively difficult to etch using plasma or reactive-ion etching techniques.

What is needed is a new technique for creating metal interconnect lines and via plugs from ductile metal alloys that do not exhibit pronounced electromigration characteristics. In addition, the technique should provide improved step coverage over prior art processes and should eliminate the metal etch step altogether.

## Summary of the Invention

The present invention dramatically improves the step coverage of a ductile metal used as an interconnect material within an integrated circuit by utilizing mechanical energy to force the ductile metal into channels and vias. The process begins with a wafer having a dielectric layer, the upper surface of which has been planarized. Following a first masking step, channels are etched in the upper surface of the dielectric layer. Following a second masking step, vias are etched through the dielectric layer to the conductive layer below where contact is to be made. A layer of ductile metal is then deposited on top of the dielectric layer by any one of a number of means (e.g., sputter deposition or chemical vapor deposition). The ductile metal layer is then mechanically deformed so that it is worked into the vias and interconnect channels. Mechanical deformation is accomplished by maintaining a rotating disk or vibrating pad in contact with the metal layer. Disks and pads made of metal or polymeric compounds have been used successfully. The wafer is then slurry polished until all excess metal has been removed and the topography is coplanar with the planar surface of the dielectric layer. Metal remains only in the vias and interconnect channels. This method of creating via plugs and interconnect channels has several important advantages over the prior art. Firstly, via walls may be etched more steeply since mechanical energy is used to force metal into them. Secondly, no etching of metal layers is necessary for the creation of either interconnect lines or via plugs. Rather, vias and channels are etched in the planarized dielectric layer, and these channels are filled with metal using the aforementioned process. The fact that no etching is required permits the use of nearly any ductile metal cr alloy thereof, without regard for the ease with which it is etched.

## Brief Description of the Drawings

Figure 1 is an isometric view of a portion of a partially-processed semiconductor wafer which depicts a field-effect transistor (FET) having as a drain a conductively-doped region within a silicon substrate, all of which is overlaid by a planarized dielectric layer of silicon dioxide;

Figure 2 is an isometric view of the wafer portion of Figure 1, following a first photomasking step which defines an interconnect channel and a first dry oxide etch which creates the channel;

Figure 3 is an isometric view of the wafer portion of Figure 2, following removal of the first photo mask;

Figure 4 is an isometric view of the wafer portion of Figure 3, following a second photomasking step which defines an interconnect via superimposed on the previously created channel and a second dry oxide etch which creates the via;

Figure 5 is an isometric view of the wafer portion of Figure 4, following removal of the second photo mask;

Figure 6 is an isometric view of the wafer portion of Figure 5, with the frontal portion up to the plane defined by broken line 6-6 removed to show a cross-section through the via;

Figure 7 is an isometric view of the wafer portion of Figure 5, following the chemical vapor deposition of a ductile metal layer on top thereof;

Figure 8 is an isometric view of the wafer portion of Figure 7, with the frontal portion up to the plane defined by broken line 8-8 removed to show a cross-section through the via;

Figure 9 is an isometric view of the wafer portion of Figure 7, following the mechanical smearing or deformation of the metal layer;

Figure 10 is an isometric view of the wafer portion of Figure 9, with the frontal portion up to the plane defined by broken line 8-8 removed to show a cross-section through the via;

Figure 11 is an isometric view of the wafer portion of Figure 9, following a slurry polish that removes all excess metal; and

Figure 12 is an isometric view of the wafer portion of Figure 11, with the frontal portion up to the plane defined by broken line 12-12 removed to show a cross-section through the via.

Preferred Embodiment of the Invention

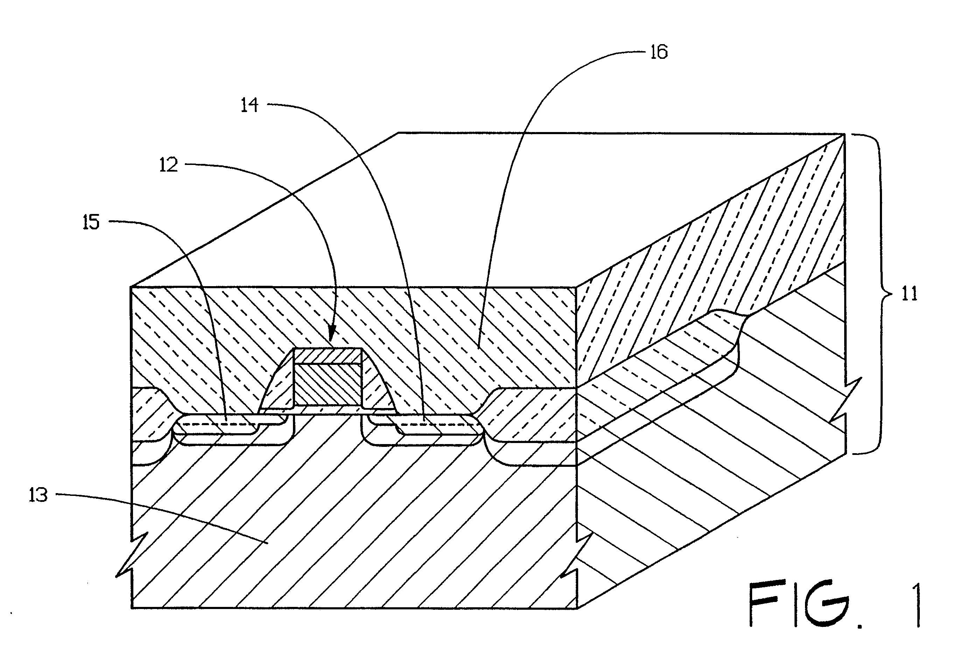

A portion of a partially-processed semiconductor wafer 11 is shown in Figure 1. A field-effect transistor (FET) 12 has been constructed on top of a silicon substrate 13, a portion of which has been doped to serve as the FET drain 14, and another portion of which has been doped to serve as the FET source 15. All topography has been covered by a silicon dioxide dielectric layer 16 the upper surface of which has been planarized. In order to completely describe the present invention, it will be assumed that an interconnect line must be formed on top of dielectric layer 16 and that the interconnect line must connect with FET drain 14.

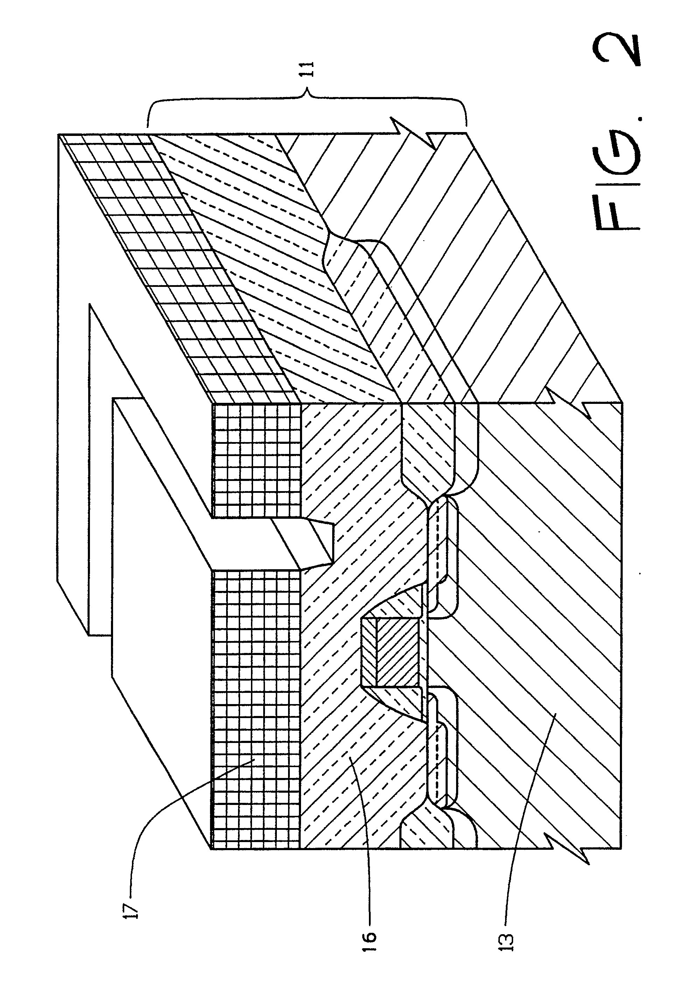

Referring now to Figure 2, a first photoresist mask 17 has been applied to wafer 11 on top of dielectric layer 15. First photo mask 17 defines the geometries of desired interconnect lines on the surface of dielectric layer 15. Only a single interconnect line will be created on the wafer portion shown in this Figure. A first dry oxide etch forms interconnect line channel 18 which will be filled with ductile metal in a later step, thus becoming one of the desired interconnect lines on the wafer.

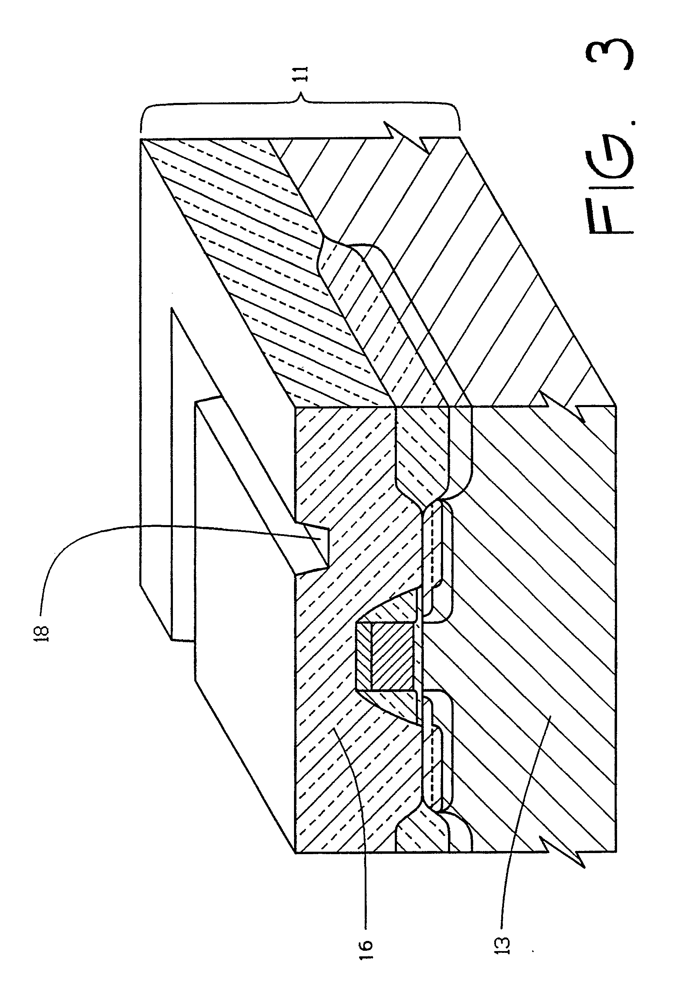

Referring now to Figure 3, channel 18 etched in dielectric layer 15 is shown following the removal of first photo mask 17.

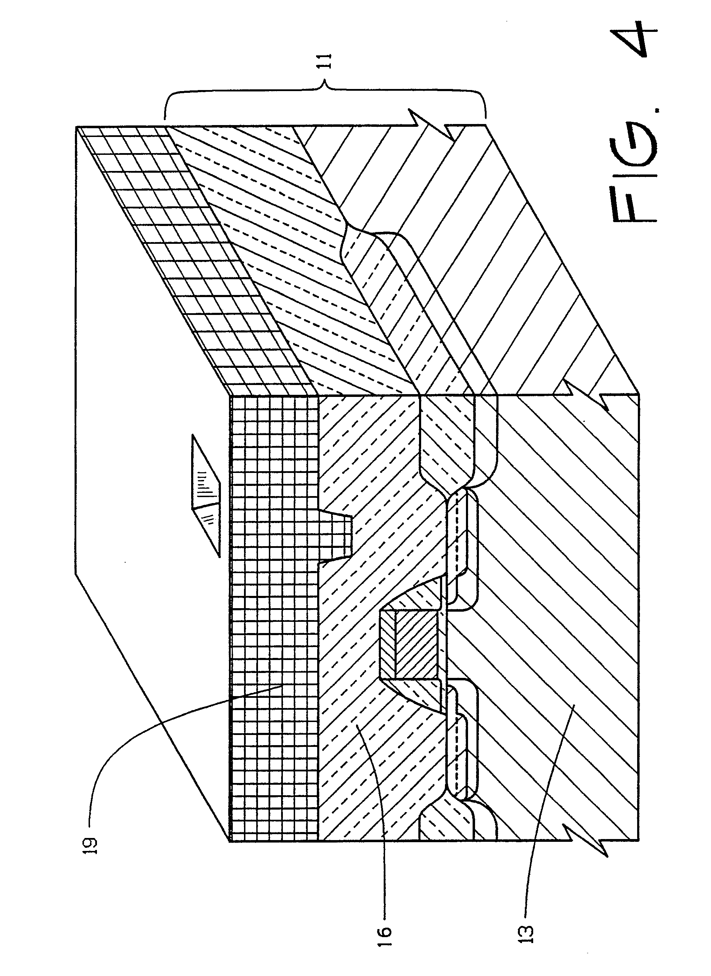

Referring now to Figure 4, a second photoresist mask 19 which defines interconnect vias, has been applied to wafer 11. A single via will be formed on the wafer portion depicted in this Figure.

The via will be positioned such that it, at least partially, coincides with the already etched channel 18 so that when the via plug and interconnect line are formed, they will be in electrical communication with one another. A second dry oxide etch forms via 20 which, along with channel 18, will be filled with ductile metal in a later step.

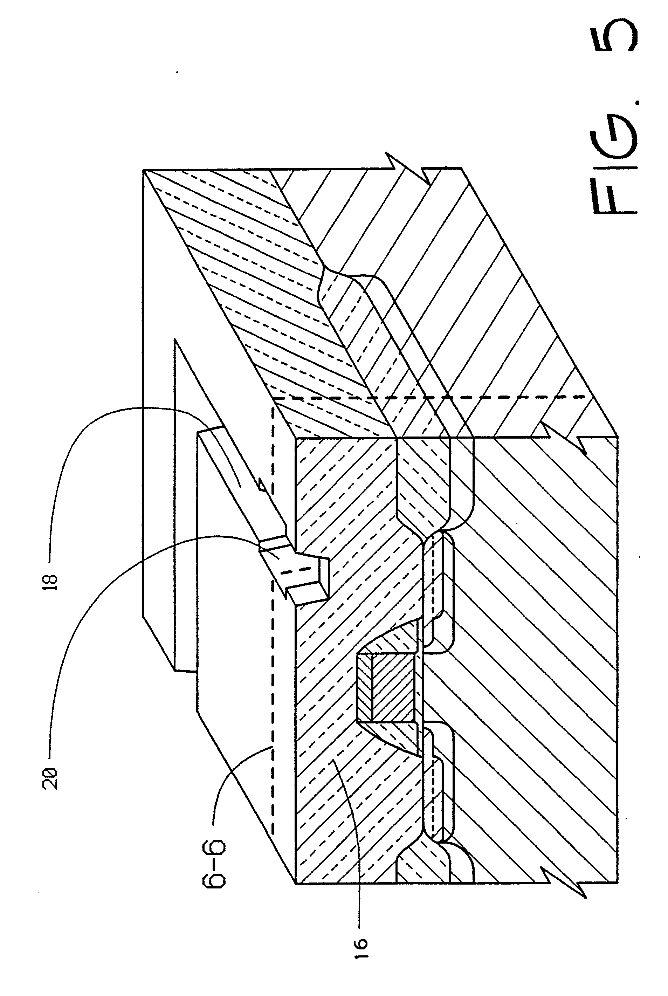

Referring now to Figure 5, channel 18 and via 20 are shown following the removal of second photo mask 19.

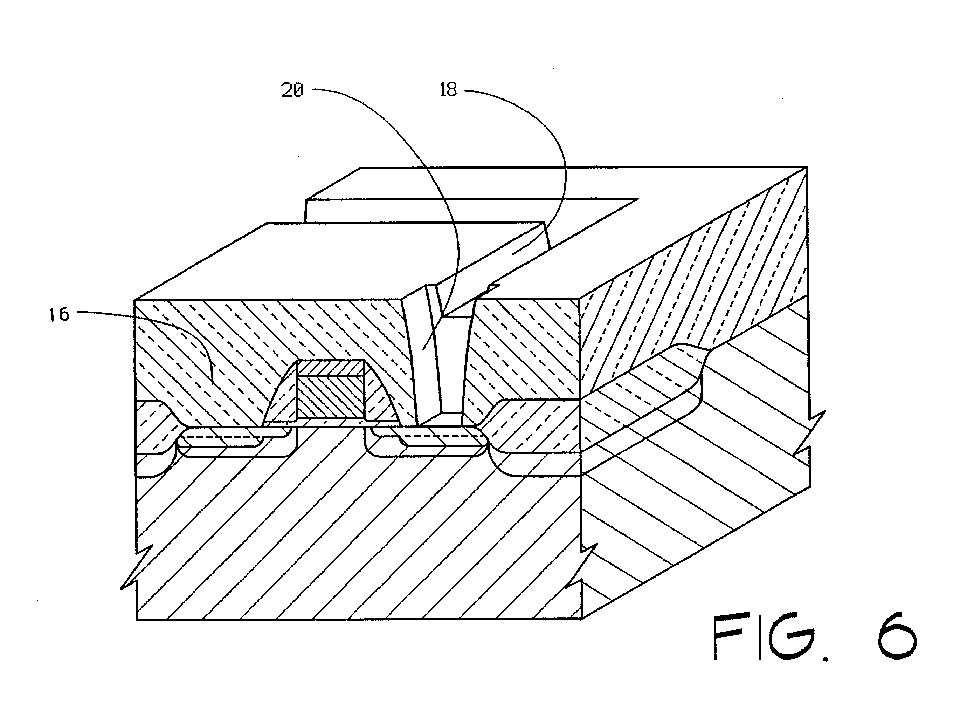

Referring now to Figure 6, which is a cross-sectional view through the plane defined by broken lines 6-6 of Figure 5, the internal geometry of via 20 is more readily apparent. FET drain 14 is exposed by via 20.

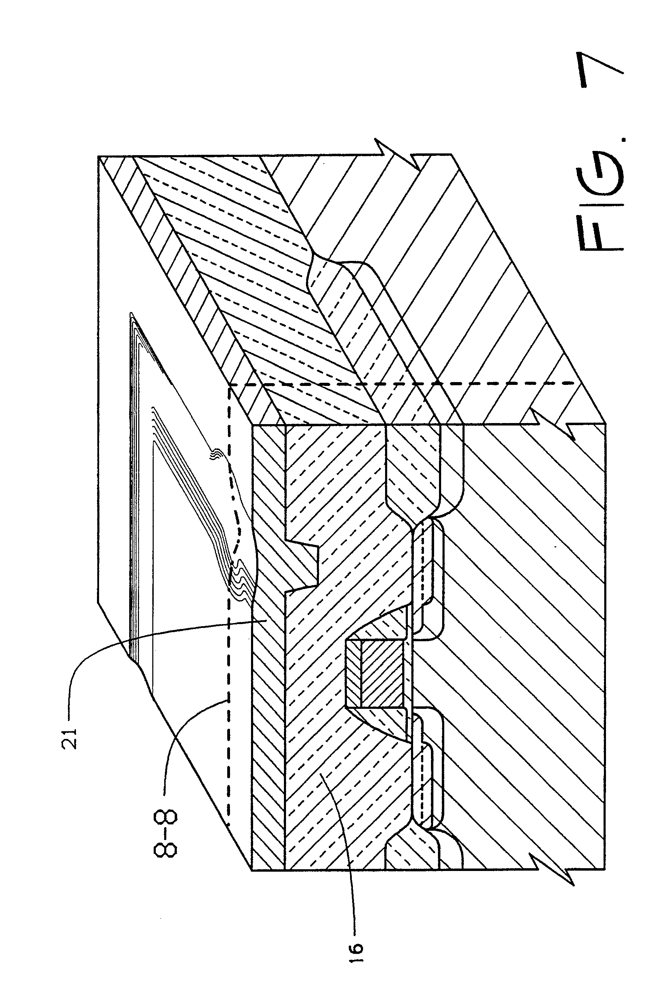

Referring now to Figure 7, a conformal ductile metal layer 21 has been deposited on top of dielectric layer 15. Deposition may be done by any number of means such as chemical vapor deposition or sputter deposition.

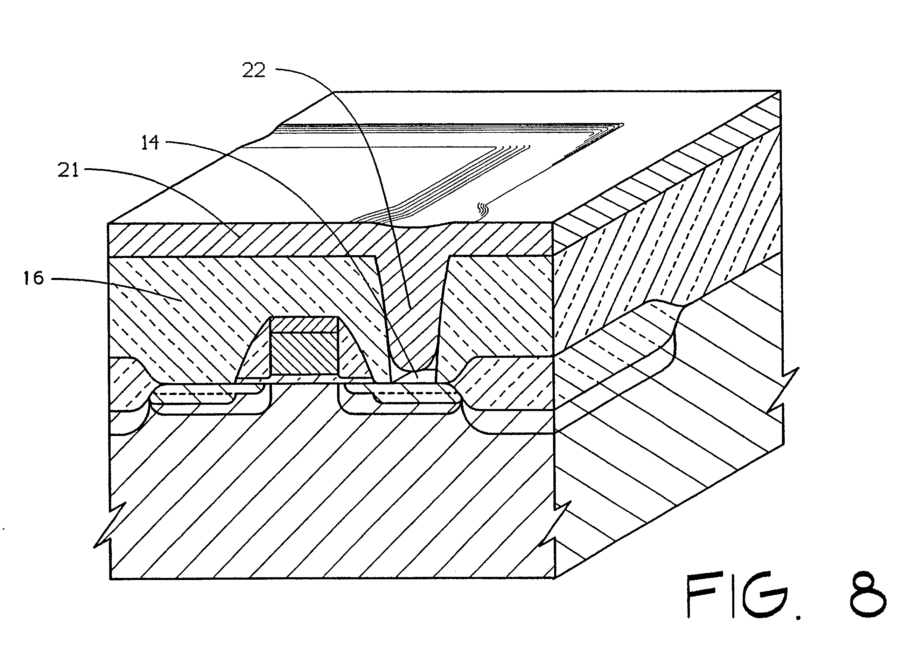

Referring now to Figure 8, which is a cross-sectional view through the plane defined by broken lines 8-8 of Figure 7, step coverage of the via plug 22 within the via is poor. In this case, via plug 22 doesn't contact FET drain 14. Hence, the transistor would be inoperative if no further steps were taken to improve the quality of this connection.

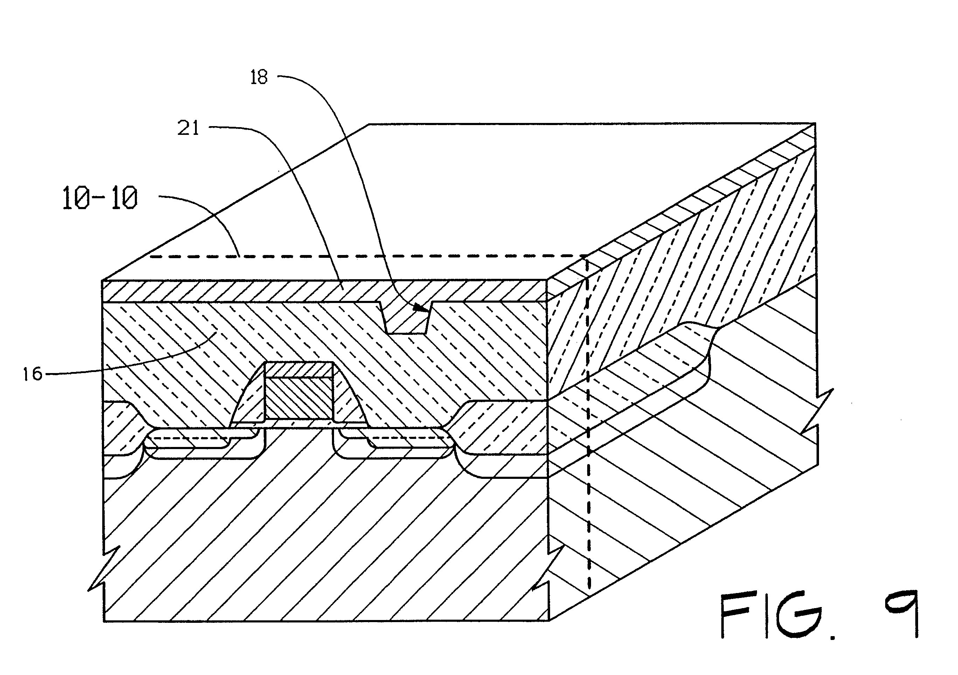

Referring now to Figure 9, ductile metal layer 21 has been deformed by smearing using a rotating disk or a vibrating pad held in contact therewith. The disk or pad may be made of any material having sufficient structural integrity to transfer mechanical energy to metal layer 21. As metal layer 21 is deformed by this input of mechanical energy, the metal of layer 21 is forced into channel 18 and via 20 (not shown in this Figure). Disks made of metal and durable polymer plastics such as tetrafluoroethylene have been used successfully. Rotation of a disk may be unidirectional or reciprocatingly bidirectional, with bidirectional being the preferred mode. Bidirectional smearing tends to compact the metal within the via or channel more uniformly. If a vibrating pad is used for the smearing operation, it may be vibrated in either a omnidirectional or orbital mode.

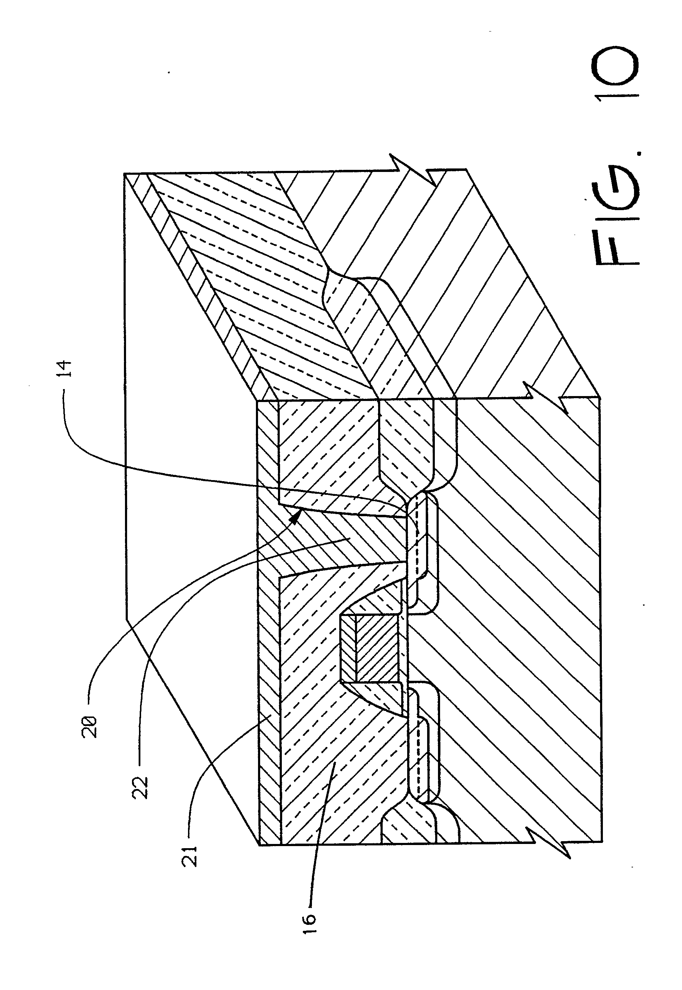

Referring now to Figure 10, which is a cross-sectional view through the plane defined by broken lines 10-10 of Figure 9, step coverage of the via plug 22 within via 20 has been greatly improved, with sound plug-to-FET-drain contact having been obtained.

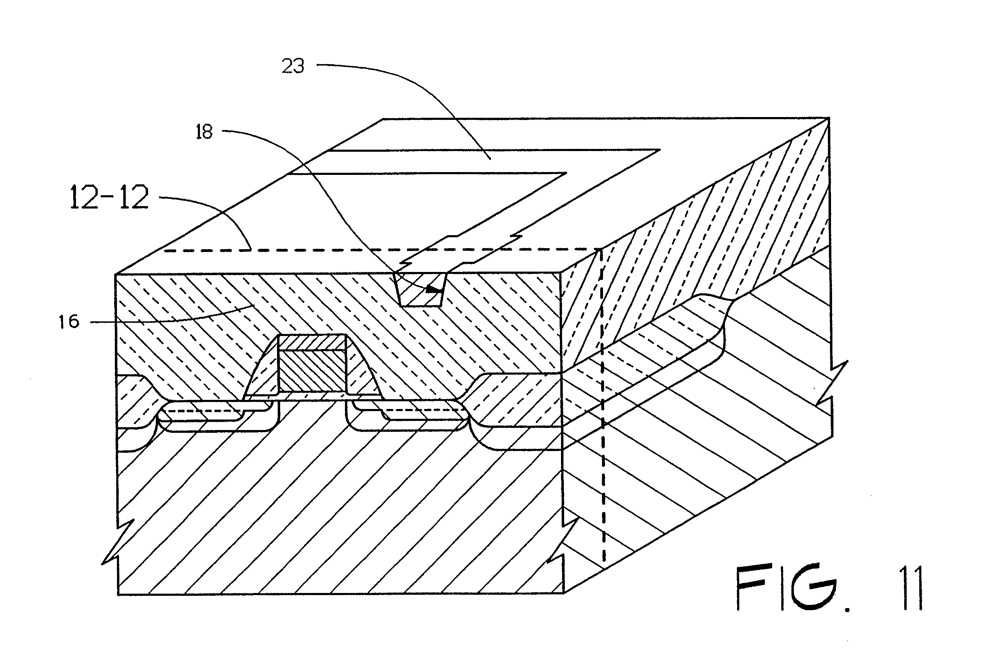

Referring now to Figure 11, a slurry polish has been used to remove all excess metal from metal layer 21 from the planarized surface of dielectric layer 15, such that ductile metal remains only in channel 18 and via 20 (not shown in this Figure). At this point via plug 22 (not shown in this Figure) and interconnect line 23 are fully formed. An optional high-temperature step may be used to recrystallize the metal which forms via plug 22 and interconnect line 23.

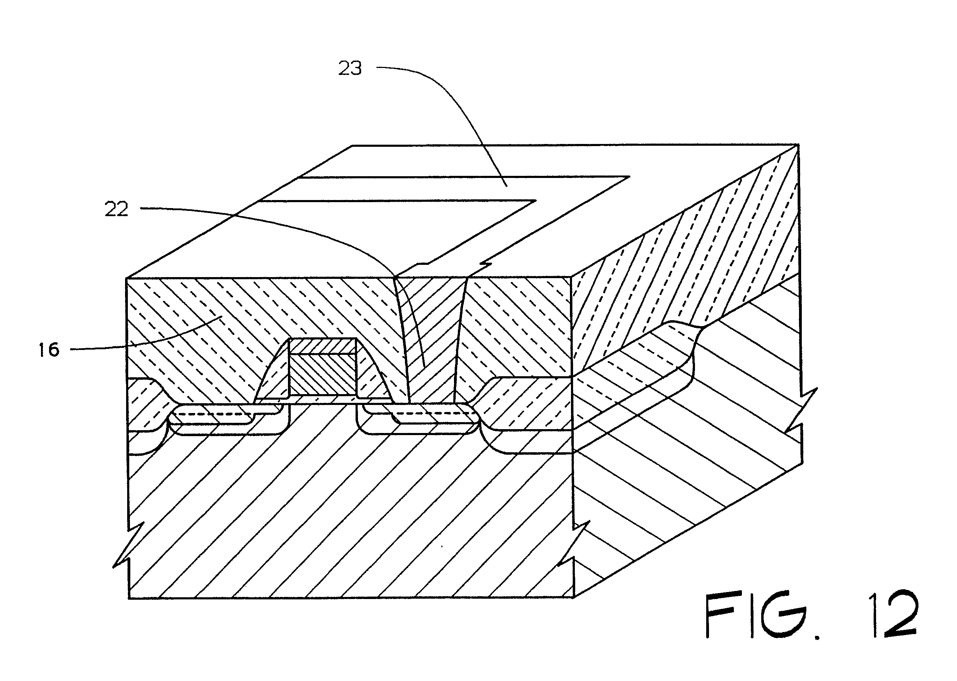

Referring now to Figure 12, which is a cross-sectional view through the plane defined by broken lines 12-12 of Figure 11, the final appearance of the cross-section of via plug 22 is shown.

Although methods have been disclosed for forming both conductive via plugs and interconnect lines, the techniques for creating both are essentially the same. Both via plugs and interconnect lines are conductive paths, the difference being that via plugs provide vertical conductive paths, while interconnect lines provide horizontal conductive paths. In order to create either a via or an interconnect line utilizing the present invention, a depression (whether via or channel) is etched into a dielectric layer, ductile metal is deposited on top of the dielectric layer, the ductile metal is then mechanically deformed by smearing using a disk or pad, such as those heretofore described, so that metal is forced into the depression. A slurry polishing operation removes the excess metal, leaving metal only in the depression.

Although only several embodiments of the invention have been described herein, it will be apparent to one skilled in the art that changes and modifications may be made thereto without departing from the spirit and the scope of the invention as claimed.

**Claims**

1. A method of forming a conductive path of ductile metal within an exposed, planarized dielectric layer (16) of an integrated circuit comprising the following sequence of steps:
   a) masking said dielectric layer with a photoresist mask (17 or 19) in order to define the geometries of said conductive path;
   b) etching said dielectric layer (16) in order to create a depression (18 or 20) within said dielectric layer (16);
   c) removing said photoresist mask (17 or 19);
   d) deposition of a ductile metal layer (921) on top of said dielectric layer (16);
   e) smearing the metal layer (21) in order to force metal from said ductile metal layer more completely into said depression (18 or 20); and
   f) removing excess metal that is not in said depression (18 or 20).

2. The method of Claim 1, which further comprises a high-temperature step following the removal of excess metal, said high-temperature step causing the metal remaining in said depression (18 or 20) to recrystallize.

3. A method of forming an interconnect line within an exposed planarized dielectric layer (16) of an integrated circuit, said interconnect line communicating with a conductive plug within a via that contacts a conductive layer (14) below said dielectric layer (16), said method comprising the following steps:
   a) masking said dielectric layer (16) with a first photoresist mask (17) in order to define the geometries of said interconnect line;
   b) subjecting said dielectric layer (16) to a first etch in order to create an interconnect line channel (18) in said dielectric layer (16);
   c) removing said first photoresist mask (17);
   d) masking said dielectric layer with a second photoresist mask (19) in order to define the geometries of said via, said via being at least partially coincident with said interconnect line channel (18);
   e) subjecting said dielectric layer (16) to a second etch in order to create a via (20) which extends through said dielectric layer (16) to said conductive layer (14);
   f) deposition of a ductile metal layer (21) on top of said dielectric layer (16);
   g) smearing the ductile metal layer (21) in order to force metal from said metal layer more completely into said via (20) and into said channel (18); and
   h) removing excess metal that which is not in said via (20) or in said channel (18).

4. The method of Claim 3, which further comprises a high-temperature step following the removal of excess metal, which recrystallizes the metal remaining in said via (20) and in said channel (18).

5. The method of any of Claims 1 to 4, wherein the removal of excess metal is accomplished with a slurry polishing operation.

6. The method of any of claims 1 to 5, wherein said smearing of the metal layer (21) is accomplished with a rotating disk maintained in contact with said metal layer (21).

7. The method of Claim 6, wherein said disk is made of a durable polymer plastic material.

8. The method of Claim 6, wherein said disk is made of metal.

9. The method of any of Claims 6 to 8, wherein said disk is rotated in a reciprocatingly bidirectional manner.

10. The method of any of Claims 1 to 5, wherein said smearing of the metal layer is accomplished with a non-rotating, vibrating pad maintained in contact with said metal layer.

11. The method of Claim 10, wherein said pad is made of a durable polymer plastic material.

12. The method of Claim 10, wherein said pad is made of metal.

FIG. 1

FIG. 2

EP 0 430 040 A2

FIG. 3

FIG. 4

FIG. 5

FIG. 6

EP 0 430 040 A2

FIG. 7

FIG. 8

22

14

21

16

FIG. 9

EP 0 430 040 A2

FIG. 10

EP 0 430 040 A2

FIG. 11

23

22

16

FIG. 12

EP 0 430 040 A2